(19) Europäisches Patentamt

European Patent Office

Office européen des brevets

(11) Veröffentlichungsnummer: **0 221 351 B1**

# (12) EUROPÄISCHE PATENTSCHRIFT

(45) Veröffentlichungstag der Patentschrift: **25.09.91**

(21) Anmeldenummer: **86113573.9**

(22) Anmeldetag: **02.10.86**

(51) Int. Cl.⁵: **H01L 23/58**

(54) **Integrierte Halbleiterschaltung mit einem elektrisch leitenden Flächenelement.**

(30) Priorität: **22.10.85 DE 3537590**

(43) Veröffentlichungstag der Anmeldung:
**13.05.87 Patentblatt 87/20**

(45) Bekanntmachung des Hinweises auf die
Patenterteilung:
**25.09.91 Patentblatt 91/39**

(84) Benannte Vertragsstaaten:
**AT BE DE FR GB IT NL SE**

(56) Entgegenhaltungen:
**EP-A- 0 085 117**
**DE-A- 3 200 953**
**FR-A- 2 471 051**
**GB-A- 2 097 581**
**US-A- 4 067 099**

(73) Patentinhaber: **Siemens Aktiengesellschaft**
**Wittelsbacherplatz 2**
**W-8000 München 2(DE)**

(72) Erfinder: **Schrenk, Hartmut, Dr.**
**Fasanenweg 22**
**W-8013 Haar(DE)**

Rank Xerox (UK) Business Services

## Beschreibung

Die Erfindung betrifft eine integrierte Halbleiterschaltung, wie sie im Oberbegriff des Anspruchs 1 beschrieben ist. Eine derartige Halbleiterschaltung ist aus US-A- 4 067 099 bekannt.

Bekanntlich werden MOS-Schaltungen in mehreren Verfahrensschritten hergestellt, in welchen das verwendete Halbleitersubstrat auf die gewünschte Weise strukturiert wird. Umgekehrt kann durch Analyse der Struktur die Funktion und Eigenschaft der Schaltung ermittelt werden. Mit Hilfe eines Lichtmikroskops ist es möglich, eine lichtoptische Analyse durchzuführen. Auf diese Weise kann beispielsweise auch die in einem ROM gespeicherte Information bekannt werden. Bei elektrisch programmierbaren Speichern (E²PROMs) kann der Speicherinhalt einer elektrischen Analyse unterzogen werden, beispielsweise durch Abtastung des Ladungszustandes der Speicherzellen mit Elektronenstrahlen und Untersuchung des Potentialkontrastes. Eine indirekte Analyse durch Rückwirkung des Speicherzustandes auf die notwendigerweise mit dem Speicher verschaltete Peripherielogik ist ebenfalls nicht auszuschließen. Ein Beispiel dafür ist die Messung des Potentials auf den Spaltenleitungen nach Einstellung einer Speicheradresse. Derartige Messungen setzen allerdings voraus, daß die Oberfläche vollständig offenliegt und elektrooptisch abgetastet werden kann.

Es gibt jedoch Anwendungsfälle für integrierte Schaltungen, insbesondere für Speicherschaltungen, in welchen eine Analyse der Schaltung und des Speicherinhalts für Unberechtigte verhindert werden muß. Anwendungsbeispiele dafür sind Sicherheits- und Zugriffssysteme, Abrechungs- und Registriersysteme und Debit- oder Kreditsysteme, bei welchem sog. Chipkarten eingesetzt werden. Auf jeder Karte sind dabei Daten gespeichert, die vor jeder Anwendung der Karte geprüft werden und die einen Mißbrauch der Karte verhindern sollen. Ferner kann jeder Chip mit einer speziellen Sicherheitslogikschaltung versehen sein, welche die Auslöseschaltung des Speichers sperren oder aber das Auslesen von einer Freigabeprozedur abhängig machen soll. Die Möglichkeit einer Analyse der Schaltung oder des Speicherinhalts in betrügerischer Absicht kann daher die Zuverlässigkeit des betreffenden Systems gefährden.

Der Erfindung liegt daher die Aufgabe zugrunde, eine integrierte Schaltung der o.g. Art anzugeben, mit welcher eine elektrische Analyse der Schaltung und des Schaltungszustandes verhindert wird.

Versuche, die gestellte Aufgabe zu lösen, sind bekannt. Aus der DE-A-30 44 983 ist es beispielsweise bekannt, Bereiche zwischen Leiterbahnen durch metallische Flächenelemente aufzufüllen, die in derselben Ebene liegen wie die Leiterbahnen und die mit diesen nicht elektrisch verbunden sind. Aus demselben Dokument ist auch bekannt, die Leiterbahnen flächenmäßig so zu verändern und zu vergrößern, daß sie auf den Betrachter nicht mehr wie Leiterbahnen wirken, sondern wie beispielsweise elektrische Abschirmflächen. Diese Maßnahmen mögen zwar im Einzelfall den Fachmann, der mit solchen Maßnahmen versehene Schaltungen und deren elektrische Zustände analysieren will, momentan verwirren. Ein ernsthafter, sicher wirkender Schutz vor zielstrebig durchgeführten Analysen bietet jedoch diese bekannte Maßnahme nicht. Beispielsweise nach Abätzen von über den Leiterbahnen liegenden Deck- und Passivierungsschichten bis auf die Leiterbahnen lassen sich die Schaltungen dann jederzeit lichtoptisch und/oder mit Hilfe von Methoden zur Feststellung von Potentialkontrasten untersuchen.

Die gestellte Aufgabe wird jedoch zuverlässig mit den im kennzeichnenden Teil des Patentanspruches 1 aufgeführten Merkmalen gelöst.

Vorteilhafte Aus- und Weiterbildungen der Erfindung sind in Unteransprüchen gekennzeichnet.

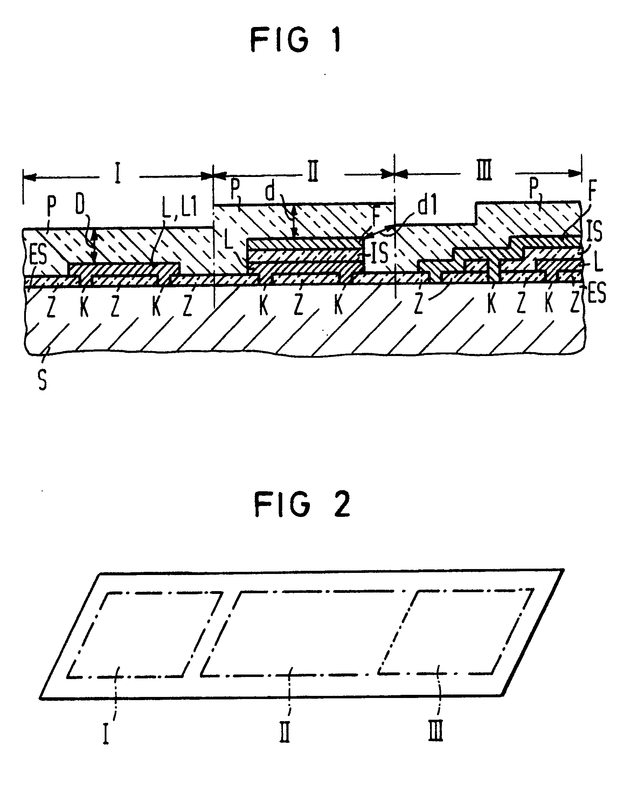

Im folgenden wird die Erfindung anhand der Figur 1 näher erläutert. Figur 1 zeigt eine Schnittzeichnung durch eine erfindungsgemäße schematisierte integrierte Halbleiterschaltung.

Ein Halbleiterkristall, beispielsweise aus Silizium oder Galliumarsenid dient in Form eines Substrates S als mechanischer Träger für die gesamte integrierte Halbleiterschaltung. Wie bei integrierten Halbleiterschaltungen üblich, sind im Bereiche einer der Hauptflächen des Substrates S elektrische Strukturen ES angeordnet. Sie sind die einzelnen Schaltelemente einer integrierten Halbleiterschaltung wie z.B. Transistoren, Kapazitäten, Widerstände und Dioden. Aus Übersichtlichkeitsgründen wurde in Figur 1 auf die Darstellung einzelner elektrischer Strukturen ES verzichtet; das Bezugszeichen ES deutet nur den Bereich an, in dem sich die Strukturen ES befinden. Leiterbahnen L verbinden die einzelnen elektrischen Strukturen ES miteinander, so daß sich die jeweils gewünschte Schaltung ergibt. Um unerwünschte Kurzschlüsse zwischen den Leiterbahnen L und den elektrischen Strukturen ES zu vermeiden, befindet sich zwischen den Leiterbahnen L und den elektrischen Strukturen ES noch eine sogenannte Zwischenoxidschicht Z. Bei der Herstellung der integrierten Halbleiterschaltung kann die Zwischenoxidschicht Z beispielsweise als thermisches Oxid aufgewachsen werden. Die Leiterbahnen L sind mittels Kontaktlöchern K mit dem elektrischen Strukturen ES verbunden. Oberhalb der Leiterbahnen L und der Zwischenoxidschicht Z schließen sich noch mindestens eine Passivierungsschicht P und gegebenenfalls weitere Deckschichten (nicht dargestellt) an. Eine solcherart aufgebaute integrierte Halbleiterschaltung weist keinerlei Schutz gegenüber Analysen auf. Insbesondere bei nichtflüchtigen Halbleiterspeichern läßt sich sogar der momentane Schaltungszustand, d.h. der Speicherinhalt, erfassen und auswerten. Eine integrierte Halbleiterschaltung nach dem Stande der Technik weist deshalb in derselben Ebene, in der sich die Leiterbahnen L befinden, d.h. also oberhalb der elektrischen Strukturen ES Flächenelemente auf, die bis auf einen gewissen Abstand seitlich an die Leiterbahnen L heranreichen. Dies bietet jedoch, wie bereits ausgeführt, keinen Schutz vor Analyse und Auslesen von Daten, denn nach Abtragen der Passivierungsschicht P liegen die Leiterbahnen L offen und sind voll zugänglich.

Die erfindungsgemäße integrierte Halbleiterschaltung hingegen weist zwischen der Ebene der Leiterbahnen L und der Passivierungsschicht P ein oder mehrere Flächenelemente F auf, die folgenden Mindestbedingungen genügen:

1. Sie bedecken einen Teil der gesamten Oberfläche der integrierten Schaltung, wodurch ein Teil der Leiterbahnen L, ein Teil des Substrates S und ein Teil der elektrischen Strukturen ES bedeckt ist. Dies bedeutet, daß sich die Flächenelemente F mindestens teilweise nicht in der gleichen Ebene befinden wie die Leiterbahnen L.

2. Sie sind durch eine Isolierschicht IS von den bedeckten Leiterbahnen L elektrisch getrennt.

3. Die Flächenelemente F sind mindestens gleich dick wie die Leiterbahnen L.

4. Sie haben dieselben chemischen Eigenschaften wie die Leiterbahnen L, d.h. insbesondere, sie weisen bezüglich Ätzbehandlungen dasselbe Verhalten auf wie die Leiterbahnen L.

Eine weitere, erfindungsgemäße Eigenschaft weisen die Passivierungsschicht P und die gegebenenfalls vorhandenen Deckschichten auf: sie sind wenigstens an den Stellen, an denen die Flächenelemente F Leiterbahnen L bedecken, mindestens gleich dick (vgl. Maß d) oder dicker als an Stellen (vgl. Maß D) oberhalb von solchen Leiterbahnen L1, die frei von einer Bedeckung durch Flächenelemente F sind.

Eine solche erfindungsgemäße integrierte Halbleiterschaltung ist weitestgehend sicher vor optischer und/oder elektrischer Analyse. Im folgenden wird erläutert, wie der Schutz wirkt. Es sei dabei beispielhaft angenommen, die in Figur 1 dargestellte integrierte Halbleiterschaltung sei eine nichtflüchtige Halbleiterspeicherschaltung, nach der Art eines E²PROM. Der in Figur 1 mit I bezeichnete Bereich stelle eine eventuell in der Halbleiterspeicherschaltung enthaltene Sicherheitslogikschaltung dar, die einen unberechtigten elektrischen Zugriff auf die in der Speicherschaltung gespeicherten Daten unterbinden soll, beispielsweise durch Verarbeiten eines extern einzugebenden Geheimcodes. Anstelle der Sicherheitslogikschaltung oder zusätzlich dazu kann der Bereich I auch für die Funktion der Halbleiterschaltung grundlegend notwendige Schaltungsteile enthalten wie Clockgeneratoren oder Substratvorspannungsgeneratorschaltungen. Diese Schaltungen und Schaltungsteile sind als elektrische Strukturen ES mittels Leiterbahnen untereinander und mit restlichen Teilen der integrierten Halbleiterschaltung verbunden. Dieses ist, stark schematisiert als eine einzige Leiterbahn L1 dargestellt. Der Bereich I ist erfindungsgemäß frei von den Flächenelementen F. Der Bereich II stellt einen Bereich dar, der beispielsweise das der Halbleiterspeicherschaltung zugehörige Speicherzellenfeld sowie zu diesem periphere Schaltungsteile enthält, deren zugehörige Leiterbahnen L zumindest teilweise Logikpegel aufweisen, die entweder aus dem Speicherzellenfeld ausgelesenen Daten oder für das Speicherzellenfeld wichtigen, relevanten Daten (z.B. Adreßsignalen) entsprechen. Der Bereich II weist mindestens ein Flächenelement F auf. Erfindungsgemäß bedeckt es ausschließlich einen Teil aller Leiterbahnen L der integrierten Halbleiterschaltung. Der Bereich III sei zunächst einmal außer acht gelassen.

Versucht nun jemand unbefugt, den Halbleiterspeicher oder seinen Speicherinhalt zu analysieren oder auszulesen (es sei angenommen, daß unbefugtes "einfaches Auslesen" durch die vorgenannte, in die integrierte Schaltung eingebaute Sicherheitslogikschaltung unterbunden ist), so wird er im allgemeinen die Passivierungsschicht P und die gegebenenfalls vorhandenen weiteren Deckschichten abzulösen versuchen (beispielsweise mittels Ätzen). Aufgrund der angegebenen Schichtdickenverhältnisse (Maße d, D, d1) ist spätestens zu dem Zeitpunkt, zu dem die Passivierungsschicht P oberhalb des Flächenelementes F im Bereich II entfernt ist, diese auch über der Leiterbahn L1 im Bereich I entfernt. Der Bereich I ist jetzt zwar frei zugänglich, es kann jedoch nichts analysiert werden, da er keine Leiterbahnen enthält, die Logikpegel annehmen, die dem Speicherinhalt entsprechen. Im Bereich II, in dem sich ja angenommenermaßen periphere Schaltungsteile sowie das Speicherzellenfeld des Halbleiterspeichers befinden, verhindert das Flächenelement F einen zu Analysezwecken notwendigen Eingriff (beispielsweise Anlegen bestimmter Spannungen an die Ausgänge bestimmter, durch die Sicherheitslogikschaltung in ihrer Funktion gesperrter Dekoder). Es bleibt also nichts anderes übrig, als das Flächenelement F bzw. die Flächenelemente F im Bereich II ebenfalls wegzuätzen, einschließlich der darunterliegenden Isolierschicht IS. Da aber auch die Leiterbahn L1 im Bereich I zu diesem Zeitpunkt freiliegt, somit dem Ätzmittel zugänglich ist, höchstens gleich dick ist wie das Flächenelement F und gleiche chemische Eigenschaften wie dieses (F) aufweist (insbesondere bezüglich des Ätzverhaltens), wird bei einem Abätzen des Flächenelementes F im Bereich II auch die Leiterbahn L1 im Bereich I mit weggeätzt. Im Endeffekt sind dann zwar die peripheren Schaltungsteile und das Speicherzellenfeld im Bereich II zugänglich, eine Analyse ist jedoch trotzdem nicht möglich, weil im Bereich I die Leiterbahnen, in Figur 1 angedeutet durch die Leiterbahn L1, zerstört (weggeätzt) sind. Damit können die im Bereich I befindlichen Schaltungsteile nicht mehr funktionieren, was jegliche Funktion im Bereich II unmöglich macht. In einem einzigen Satz ausgedrückt: eine erfindungsgemäße integrierte Halbleiterschaltung wird beim Versuch, sie zu analysieren oder im Falle von nichtflüchtigen Halbleiterspeichern, ihren Inhalt auszulesen, aufgrund ihres vorteilhaften Aufbaus gewollt und zuverlässig mindestens in ihrer elektrischen Funktion zerstört.

Die erfindungsgemäße integrierte Halbleiterschaltung läßt sich mit bekannten Mitteln leicht herstellen: die elektrischen Strukturen ES und das Zwischenoxid Z sind in herkömmlichen Prozeßschritten fertigbar. Die Leiterbahnen L, die Isolierschichten IS und die Flächenelemente F sind mit den bekannten Prozeßschritten, die Herstellung von Mehrlagenverdrahtungen bei integrierten Schaltkreisen betreffend, herstellbar. Die Leiterbahnen L werden dabei als erste Metallisierungsebene aufgetragen und entsprechend den jeweiligen Schaltungserfordernissen strukturiert. Als Isolierschicht IS bietet sich z.B. Plasmaoxid an. Thermisch gewachsenes Oxid kann nicht verwendet werden, weil dabei aufgrund der auftretenden Temperaturen die darunterliegenden Leiterbahnen L verbrannt würden. Die Flächenelemente F, die ja dieselben chemischen Eigenschaften aufweisen sollen wie die Leiterbahnen L, insbesondere, was das Ätzverhalten betrifft, bestehen in vorteilhafter Weise aus demselben Material wie die Leiterbahnen L. Sie werden entsprechend als zweite Metallisierungsebene aufgetragen, mindestens in derselben Dicke wie die erste Metallisierungsebene für die Leiterbahnen L und gemäß den Erfordernissen des erwünschten Schutzes strukturiert.

Es ist vorteilhaft, wenn sowohl die Leiterbahnen L, L1 als auch die Flächenelement F aus Metall, insbesondere aus Aluminium sind. Es ist auch vorteilhaft, wenn sowohl die Leiterbahnen L, L1 als auch die Flächenelemente F aus Polysilizium oder aus hochschmelzenden Siliziden sind. In einer ersten Ausführungsform der Erfindung sind die Flächenelemente F bezüglich der integrierten Schaltung elektrisch isoliert angeordnet.

In einer zweiten Ausführungsform der Erfindung sind die Flächenelemente F elektrisch mit einem der integrierten Halbleiterschaltung als Spannungsversorgung dienenden Potential verbunden. Des weiteren können mehrere Flächenelemente F miteinander verbunden sein. In einer weiteren Ausführungsform der Erfindung kann ein erstes Flächenelement F mit einem der integrierten Halbleiterschaltung als Spannungsversorgung dienenden ersten Potential verbunden sein, wohingegen ein zweites Flächenelement F mit einem der integrierten Halbleiterschaltung ebenfalls als Spannungsversorgung dienenden zweiten Potential verbunden ist.

Eine besondere Ausführungsform der Erfindung ist bei Figur 1 im Bereich III dargestellt. Diese Ausführungsform kann, wie in Figur 1 gezeigt, mit dem obengenannten Ausführungsformen der Erfindung kombiniert werden, die im Bereich II von Figur 1 dargestellt sind. Sie kann jedoch auch selbständig angewandt werden, so daß bei einer Darstellung im Querschnitt analog zur gezeigten Figur 1 der Bereich II entfallen würde, d.h. eine entsprechende integrierte Halbleiterschaltung setzt sich nur aus den Bereichen I und III zusammen.

Bei der im Bereich III der Figur dargestellten Ausführungsform der Erfindung werden zumindest ein Teil der Flächenelemente F gleichzeitig als Leiterbahnen einer zweiten Metallisierungsebene verwendet. Die Ausführungsform unterscheidet sich im wesentlichen von den vorgenannten nur dadurch, daß entsprechende Kontaktlöcher K zwischen den als Leiterbahnen wirkenden Flächenelementen F und einem Teil der elektrischen Strukturen ES angeordnet sind. Diese Kontaktlöcher K sind durch das Zwischenoxid Z hindurch gebildet und teilweise auch durch die Isolierschicht IS hindurch.

Wie vorstehend bereits beschrieben, werden zur Herstellung der erfindungsgemäßen integrierten Halbleiterschaltung herkömmliche Mehrlagenverdrahtungstechnologien verwendet.

Gemäß Fig. 2 besteht eine weitere vorteilhafte Ausführung der Erfindung darin, in einer integrierten Halbleiterschaltung zwei Bereiche (I;II,III) vorzusehen, deren erster Bereich I frei von den Flächenelementen F ist und deren zweiter Bereich II,III die Flächenelemente F enthält. Der erste Bereich I enthält dabei eine Sicherheitslogikschaltung und/oder Schaltungsteile, die unabhängig von einer Sicherheitslogikschaltung für die ordnungsgemäße Funktion der integrierten Halbeiterschaltung grundlegend notwendig sind. Dies können z.B. sogenannte Clockgeneratoren und/oder Substratvorspannungsgeneratorschaltungen sein. Unter einer Sicherheitslogikschaltung wird eine Schaltung verstanden, die, um die restlichen Teile der integrierten Halbleiterschaltung zu aktivieren, Daten benötigt, die der integrierten Halbleiterschaltung zugeführt werden müssen (Beispiel: Eintippen einer Geheimnummer beim Abheben von Bargeld mittels eines Geldausgabeautomaten und einer entsprechend präparierten Ausweiskarte wie einer Scheckkarte) und bei deren Ausbleiben (z.B. in Abhängigkeit vom Parameter "Zeit") oder beim Zuführen falscher Daten die Funktion der integrierten Halbleiterschaltung blockiert wird.

Der zweite Bereich II,III enthält erfindungsgemäß solche Schaltungsteile in seinen elektrischen Strukturen ES, deren ihnen zugeordnete und mit diesen (ES) in Kontakt stehende Leiterbahnen L für die integrierte Halbleiterschaltung oder gegebenenfalls deren Speicherinhalt relevante Logikpegel aufweisen.

**Patentansprüche**

1. Integrierte Halbleiterschaltung mit einem Substrat (S), mit einer Schicht elektrischer Strukturen (ES), mit Leiterbahnen (L) zur Verbindung der elektrischen Strukturen (ES), mit einem oder mehreren elektrisch leitenden Flächenelementen (F), die das Substrat (S) und die elektrischen Strukturen (ES) bedecken und von den Leiterbahnen (L) durch eine Isolierschicht (IS) elektrisch getrennt sind, und mit einer das Substrat (S), die elektrischen Strukturen (ES), die Leiterbahnen (L) und das Flächenelement (F) bedeckenden Passivierungsschicht (P),
**dadurch gekennzeichnet,**
   - daß das oder die Flächenelemente (F) ausschließlich in dem Bereich (II, III) der integrierten Halbleiterschaltung vorgesehen sind, der datenrelevante Logikpegel führende Leiterbahnen (L) aufweist, wodurch dieser Teil der Leiterbahnen (L), ein Teil des Substrates (S) und ein Teil der elektrischen Strukturen (ES) bedeckt sind,
   - daß das oder die Flächenelemente (F) mindestens gleich dick sind wie die Leiterbahnen (L),
   - daß das oder die Flächenelemente (F) dieselben chemischen Eigenschaften aufweisen wie die Leiterbahnen (L), und
   - daß die Passivierungsschicht (P) und eventuell weitere vorhandene Deckschichten oberhalb der Flächenelemente (F) mindestens über den Bereichen (II, III), in denen das oder die Flächenelemente (F) die Leiterbahnen (L) bedecken, gleich dick oder dicker sind als oberhalb von solchen Leiterbahnen (LI), die frei von einer Bedeckung durch das oder die Flächenelemente (F) sind.

2. Integrierte Halbleiterschaltung nach Anspruch 1,
**dadurch gekennzeichnet,**

daß die Leiterbahnen (L) und das oder die Flächenelemente (F) aus Metall, insbesondere aus Aluminium sind.

3. Integrierte Halbleiterschaltung nach Anspruch 1,
**dadurch gekennzeichnet,**
daß die Leiterbahnen (L) und das oder die Flächenelemente (F) aus Polysilizium oder aus Metallsiliziden sind.

4. Integrierte Halbleiterschaltung nach einem der vorhergehenden Ansprüche,
**dadurch gekennzeichnet,**
daß wenigstens eines der Flächenelemente (F) elektrisch isoliert angeordnet ist.

5. Integrierte Halbleiterschaltung nach einem der vorhergehenden Ansprüche,
**dadurch gekennzeichnet,**
daß wenigstens eines der Flächenelemente (F) mit einem der Halbleiterschaltung als Spannungsversorgung dienenden Potential verbunden ist.

6. Integrierte Halbleiterschaltung nach einem der vorhergehenden Ansprüche,
**dadurch gekennzeichnet,**
daß mehrere Flächenelemente (F) miteinander verbunden sind.

7. Integrierte Halbleiterschaltung nach einem der vorhergehenden Ansprüche,
**dadurch gekennzeichnet,**
daß ein erstes Flächenelement (F) mit einem der Halbleiterschaltung als Spannungsversorgung dienenden ersten Potential verbunden ist, und daß ein zweites Flächenelement (F) mit einem der Halbleiterschaltung als Spannungsversorgung dienenden zweiten Potential verbunden ist.

8. Integrierte Halbleiterschaltung nach einem der vorhergehenden Ansprüche,
**dadurch gekennzeichnet,**
daß wenigstens eines der Flächenelemente (F) als Leiterbahn dient und mit einem Teil der elektrischen Strukturen (ES) verbunden ist.

9. Integrierte Halbleiterschaltung nach einem der vorhergehenden Ansprüche,
**dadurch gekennzeichnet,**
daß der Bereich (I) der integrierten Halbleiterschaltung, der frei ist von Flächenelementen (F), Schaltungsteile enthält, die eine Sicherheitslogikschaltung darstellen, wobei eine Sicherheitslogikschaltung eine Schaltung ist, die in Abhängigkeit von einem der integrierten Halbleiterschaltung zugeführten Begriff das elektrische Funktionieren mindestens eines Teiles weiterer Schaltungsteile der integrierten Halbleiterschaltung ermöglicht und die bei Ausbleiben des Begriffs oder bei Zuführung eines im Sinne des erwarteten Begriffes falschen Begriffes dieses Funktionieren verhindert.

**10.** Integrierte Halbleiterschaltung nach Anspruch 9,
**dadurch gekennzeichnet,**
daß der Bereich (I), der frei ist von den Flächenelementen (F), Schaltungsteile enthält, die, unabhängig von einer Sicherheitslogikschaltung gemäß Anspruch 9, für die ordnungsgemäße Funktion der integrierten Halbleiterschaltung grundlegend notwendig sind.

**Claims**

**1.** Integrated semiconductor circuit comprising a substrate (S), a layer of electrical structures (ES), conductor tracks (L) for connecting the electrical structures (ES), one or more electrically conductive surface elements (F) which cover the substrate (S) and electrical structures (ES) and are electrically isolated from the conductor tracks (L) by means of an insulating layer (IS), and a passivation layer (P) covering the substrate (S), the electrical structures (ES), the conductor tracks (L) and the surface element (F), characterised in that

- the surface element or surface elements (F) are exclusively provided in the area (II, III) of the integrated semiconductor circuit which exhibits conductor tracks (L) carrying data-relevant logic levels, by means of which this part of the conductor tracks (L), a part of the substrate (S) and a part of the electrical structures (ES) are covered,
- that the surface element or surface elements (F) are at least of the same thickness as the conductor tracks (L),
- that the surface element or surface elements (F) have the same chemical characteristics as the conductor tracks (L), and
- that the passivation layer (P) and possibly other existing cover layers are of the same thickness or thicker, at least above the areas (II, III) in which the surface element or surface elements (F) cover the conductor tracks (L) above the surface elements (F), than above those conductor tracks (L1) which are free of coverage by the surface element or surface elements (F).

**2.** Integrated semiconductor circuit according to Claim 1, characterised in that the conductor tracks (L) and the surface element or surface elements (F) are of metal, particularly of aluminium.

**3.** Integrated semiconductor circuit according to Claim 1, characterised in that the conductor tracks (L) and the surface element or surface elements (F) are of polysilicon or of metal silicides.

**4.** Integrated semiconductor circuit according to one of the preceding Claims, characterised in that at least one of the surface elements (F) is arranged to be electrically insulated.

**5.** Integrated semiconductor circuit according to one of the preceding Claims, characterised in that at least one of the surface elements (F) is connected to a potential used as voltage supply for the semiconductor circuit.

**6.** Integrated semiconductor circuit according to one of the preceding Claims, characterised in that several surface elements (F) are connected to one another.

**7.** Integrated semiconductor circuit according to one of the preceding Claims, characterised in that a first surface element (F) is connected to a first potential used as voltage supply for the semiconductor circuit, and that a second surface element (F) is connected to a second potential used as voltage supply for the semiconductor circuit.

**8.** Integrated semiconductor circuit according to one of the preceding Claims, characterised in that at least one of the surface elements (F) is used as conductor track and is connected to one part of the electrical structures (ES).

**9.** Integrated semiconductor circuit according to one of the preceding Claims, characterised in that the area (I) of the integrated semiconductor circuit, which is free of surface elements (F), contains circuit sections which represent a safety logic circuit, a safety logic circuit being a circuit which, in dependence on a term supplied to the integrated semiconductor circuit, enables at least a part of further circuit sections of the integrated semiconductor circuit to function electrically and which, when the term is lacking or when a term is supplied which is wrong in the sense of the expected term, prevents this functioning.

10. Integrated semiconductor circuit according to Claim 9, characterised in that the area (I), which is free of the surface elements (F), contains circuit sections which are fundamentally necessary for the proper function of the integrated semiconductor circuit independently of a safety logic circuit according to Claim 9.

**Revendications**

1. Circuit intégré à semiconducteurs comportant un substrat (S), une couche de structures électriques (ES), des voies conductrices (L) servant à relier les structures électriques (ES), un ou plusieurs éléments de surface (F) électriquement conducteurs, qui recouvrent le substrat (S) et les structures électriques (ES) et sont séparés électriquement des voies conductrices (L) par une couche isolante (IS), et une couche de passivation (P), qui recouvre le substrat (S), les structures électriques (ES), les voies conductrices (L) et l'élément de surface (F), caracérisé par le fait
    - que le ou les éléments de surface (F) sont prévus exclusivement dans la région (II, III) du circuit intégré à semiconducteurs, qui possède des voies conductrices (L) appliquant des niveaux logiques importants pour les données, ce qui a pour effet que cette partie des voies conductrices (L), une partie du substrat (H) et une partie des structures électriques (ES) sont recouvertes,
    - que le ou les éléments de surface (F) sont au moins aussi épais que les voies conductrices (L),
    - que le ou les éléments de surface (F) possèdent les mêmes propriétés chimiques que les voies conductrices (L), et
    - que la couche de passivation (P) et éventuellement d'autres couches de revêtement existantes au moins au-dessus des régions (II, III), dans lesquelles le ou les éléments de surface (L) recouvrent les voies conductrices (L), possèdent la même épaisseur ou sont plus épaisses qu'au-dessus des voies conductrices (L1), qui ne sont pas recouvertes par le ou les éléments de surface (F).

2. Circuit intégré à semiconducteurs suivant la revendication 1, caractérisé par le fait que les voies conductrices (L) et le ou les éléments de surface (F) sont réalisés en un métal, notamment de l'aluminium.

3. Circuit intégré à semiconducteurs suivant la revendication 1, caractérisé par le fait que les voies conductrices (L) et le ou les éléments de surface (M) sont réalisés en polysilicium ou sont formés de siliciures métalliques.

4. Circuit intégré à semiconducteurs suivant l'une des revendications précédentes, caractérisé par le fait qu'au moins l'un des éléments de surface (F) est disposé en étant électriquement isolé.

5. Circuit intégré à semiconducteurs suivant l'une des revendications précédentes, caractérisé par le fait qu'au moins l'un des éléments de surface (F) est raccordé à un potentiel utilisé comme tension d'alimentation pour le circuit à semiconducteurs.

6. Circuit intégré à semiconducteurs suivant l'une des revendications précédentes, caractérisé par le fait que plusieurs éléments de surface (F) sont reliés entre eux.

7. Circuit intégré à semiconducteurs suivant l'une des revendications précédentes, caractérisé par le fait qu'un élément de surface (F) est raccordé à un premier potentiel utilisé comme tension d'alimentation pour le circuit à semiconducteurs, et qu'un second élément de surface (F) est raccordé à un second potentiel utilisé comme alimentation en tension pour le circuit à semiconducteurs.

8. Circuit intégré à semiconducteurs suivant l'une des revendications précédentes, caractérisé par le fait qu'au moins l'un des éléments de surface (F) est utilisé comme voie conductrice et est raccordé à une partie des structures électriques (ES).

9. Circuit intégré à semiconducteurs suivant l'une des revendications précédentes, caractérisé par le fait que la zone (I) du circuit intégré à semiconducteurs, qui ne comporte aucun élément de surface (F), comporte des éléments de circuit qui représentent un circuit logique de sécurité, le circuit logique de sécurité étant un circuit qui, en fonction de l'impulsion envoyée au circuit intégré à semiconducteurs, permet le fonctionnement électrique d'au moins une partie d'autres parties du circuit intégré à semiconducteurs et qui, en l'absence de cette impulsion ou bien lors de l'envoi d'une impulsion erronée par rapport à l'impulsion attendue, empêche le fonctionnement.

10. Circuit intégré à semiconducteurs suivant la revendication 1, caractérisé par le fait que la zone I, qui ne comporte aucun élément de surface (F), comporte des éléments de circuit qui, indépendamment d'un circuit logique de sécurité suivant la revendication 9, sont fondamentalement nécessaires pour le fonctionnement correct du circuit intégré à semiconducteurs.

# FIG 1

# FIG 2